(19) Europäisches Patentamt
European Patent Office
Office européen des brevets

(11) **EP 3 913 724 A2**

(12) **EUROPÄISCHE PATENTANMELDUNG**

(43) Veröffentlichungstag:
24.11.2021 Patentblatt 2021/47

(51) Int Cl.:
*H01M 10/44* (2006.01)     *H01M 10/48* (2006.01)
*H01M 10/633* (2014.01)

(21) Anmeldenummer: 21169435.1

(22) Anmeldetag: 20.04.2021

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **22.05.2020   DE 102020113829**

(71) Anmelder: **Einhell Germany AG**
**94405 Landau / Isar (DE)**

(72) Erfinder: **MITTERREITER, Anton**
**84144 Geisenhausen (DE)**

(74) Vertreter: **Hofstetter, Schurack & Partner**
**Patent- und Rechtsanwaltskanzlei**
**PartG mbB**
**Balanstrasse 57**
**81541 München (DE)**

(54) **KERNTEMPERATUR IN EINEM ZYLINDRISCHEN ENERGIESPEICHER**

(57)     Eine Kerntemperatur ($T_{ZK}$) eines Energiespeichers (1) soll auf einfache Weise ermittelt werden. Dazu wird eine Manteltemperatur ($T_{rA}$) des Energiespeichers (1) gemessen. Ebenso wird ein elektrischer Strom durch den Energiespeicher (1) gemessen. Die Kerntemperatur ($T_{ZK}$) des Energiespeichers (1) wird mit Hilfe eines thermischen Modells aus der gemessenen Manteltemperatur ($T_{rA}$) und dem gemessenen elektrischen Strom ermittelt.

Fig.1

**Beschreibung**

Die vorliegende Erfindung betrifft ein Verfahren zum Ermitteln einer Kerntemperatur in einem Energiespeicher. Darüber hinaus betrifft die vorliegende Erfindung einen Energiespeicher mit einer Steuereinrichtung zum Durchführen eines solchen Verfahrens sowie ein entsprechendes Elektrowerkzeug und ein Computerprogrammprodukt.

Bislang erfolgte die Regelung und Steuerung in Batteriemanagementsystemen für Lithium-Ionen-Akkus im Wesentlichen anhand von Strömen, Spannungen und Temperaturen, welche alle als Messparameter erhoben werden. Die Problematik besteht darin, dass vor allem Temperaturmessungen ausschließlich durch außenliegende Thermosensoren zu erfassen sind und die Temperaturmessung stets nur träge erfolgt.

Die in eine Lithium-Ionen-Zelle eingetragene thermische Energie ist entscheidend für die Belastung der Elektrochemie der Zelle, da sie sich schlussendlich zur Ausbildung des räumlichen Temperaturfelds über die dreidimensionale Zelle hinweg verantwortlich zeichnet. Je nach situativem Kontext, d.h. vorangegangene Belastungssituationen oder sich bereits eingestellte Temperaturfelder, führt ein weiterer Wärmeeintrag zu einer Veränderung des Temperaturfelds ebenso wie die Dissipation von Wärme über das Zellgehäuse an die Umgebung auch das Temperaturfeld verändert. Neben den elektrischen Potentiallagen und den in der Zelle vorhandenen elektrochemischen Stoffen oder Trägermaterialien (strukturbildend, stützend, etc.), welche den entscheidenden Antrieb für chemische und mikrophysikalische Reaktionen darstellt, ist die lokale Temperatur der wesentliche Faktor, der elektrochemischen Reaktionen (hier z.B. die Reaktionsgeschwindigkeit), aber auch mikrophysikalische Prozesse (z.B. die Ionen-Diffusivität) unterstützt, hemmt oder gar Materialkonfigurationen verändert und zerstört.

Aus der Druckschrift DE 10 2011 080 512 A1 ist bekannt, die erwartete Soll-Temperatur eines Betriebssystems für den aktuellen Betriebszustand anhand von modellbasierten Berechnungen zu ermitteln, beispielsweise anhand eines mathematischen Temperaturmodells für das Batteriesystem. Dabei können Werte des Temperaturmodells mit gemessenen Werten von Temperaturen verglichen werden. Bei Betriebsarten, in denen ein Temperierungssystem nicht aktiv ist, kann ein Temperaturmodell die Erwärmung der Batteriezellen und des Batteriesystems dynamisch berechnen und mit den gemessenen Werten der Temperatursensoren des Batteriesystems vergleichen.

Weiterhin befasst sich auch die Druckschrift US 8 829 904 B2 mit der Modellierung interner Temperaturen einer Lithium-Ionen-Zelle. Die modellierte interne Temperatur enthält ein dreidimensionales Temperaturprofil.

Des Weiteren offenbart die Druckschrift CN 105206888 A ein Überwachungsverfahren für die innere Temperatur einer Lithium-Ionen-Batterie. Es werden Lade-Entlade-Tests der Lithium-Ionen-Batterie bei unterschiedlichen Umgebungsbedingungen durchgeführt, um eine Änderungskurve der Batterieoberflächentemperatur zu erhalten. Diesbezügliche Parameter wie der Innenwiderstand der Batterie und ein Leerlaufspannungs-Temperaturkoeffizient werden überprüft. Ein Wärmekopplungsmodell der Lithium-Ionen-Batterie wird basierend auf der Wärmeproduktionsrate aufgestellt. Eine Temperaturänderung bei einem Entladeprozess kann somit simuliert werden. Die Temperaturmodellierung basiert auf der Lösung entsprechender Differenzialgleichungen.

Die oben dargestellten Modelle für die Simulation der inneren Temperaturen der jeweiligen Zelle sind in der Regel sehr aufwendig und rechenintensiv. Zeitkritische Steuerungen des jeweiligen Energiespeichers oder des damit verbundenen Elektrogeräts innerhalb von Sekundenbruchteilen sind folglich kaum realisierbar.

Die Aufgabe der vorliegenden Erfindung besteht somit darin, ein Konzept zu schaffen, auf dessen Basis eine rasche Temperatursteuerung eines Energiespeichers möglich sein kann.

Erfindungsgemäß wird diese Aufgabe gelöst durch ein Verfahren, einen Energiespeicher, ein Elektrowerkzeug und ein Computerprogrammprodukt entsprechend den unabhängigen Ansprüchen. Vorteilhafte Weiterbildungen der Erfindung ergeben sich aus den Unteransprüchen.

Entsprechend der vorliegenden Erfindung wird demnach bereitgestellte ein Verfahren zum Ermitteln einer Kerntemperatur in einem Energiespeicher durch

- Messen einer Manteltemperatur des Energiespeichers,
- Messen eines elektrischen Stroms durch den Energiespeicher und
- Ermitteln der Kerntemperatur des Energiespeichers mit Hilfe eines thermischen Modells aus der gemessenen Manteltemperatur und dem gemessenen elektrischen Strom.

Die vorliegende Erfindung basiert auf dem Gedanken, die Ermittlung der Temperatur in einem Energiespeicher auf die Ermittlung der Kerntemperatur in dem Energiespeicher zu fokussieren, wodurch sich eine Erhöhung der Simulations- beziehungsweise Modellierungsgeschwindigkeiten erreichen lässt. Die Kerntemperatur ist in der Regel diejenige Temperatur, die innerhalb des Energiespeichers am höchsten ist. Daher wird der Kern des Energiespeichers, in dem die Kerntemperatur herrscht, auch derjenige Bereich sein, der am schnellsten altert. Insofern ist die Kerntemperatur auch diejenige Temperatur, die bei der Temperaturüberwachung eine maßgebliche Rolle spielt. Vor allem sollte die Kerntemperatur, d.h. in der Regel die höchste Temperatur im Energiespeicher, einen gewissen Grenzwert nicht überschreiten. Gegebenenfalls kann dieser Grenzwert dynamisch angepasst werden.

Speziell wird in dem vorgeschlagenen Verfahren eine Kerntemperatur, d.h. eine Temperatur im Kern des Energiespeichers, ermittelt. Der Kern des Energiespeichers wird in der Regel dessen geometrischer Mittelpunkt beziehungsweise ein Bereich um den geometrischen Mittelpunkt sein. Bei gewickelten Energiespeichern, wie etwa gewickelten Lithium-Ionen-Akkus wird der Kern beziehungsweise Kernbereich auf der Wickelachse liegen. Typischerweise wird der Kern in der axialen Mitte liegen. Asymmetrie beziehungsweise Inhomogenitäten im Aufbau können aber auch dazu führen, dass die höchsten Temperaturen nicht exakt im geometrischen Mittelpunkt des Energiespeichers zu erwarten sind. In solchen Fällen kann der Kern auch etwas außerhalb der geometrischen Mitte liegen. Beispielsweise kann der Kern bei einem gewickelten Energiespeicher etwas in axialer Richtung gegenüber der Mitte verschoben sein.

In einem ersten Schritt des erfindungsgemäßen Verfahrens erfolgt ein Messen einer Manteltemperatur des Energiespeichers. Beispielsweise ist der Energiespeicher zylindrisch und die Manteltemperatur wird am Zylindermantel, also an der äußeren Oberfläche des Energiespeichers gemessen. Falls der Energiespeicher eine von einem Zylinder abweichende geometrische Gestalt, wie etwa die eines Quaders, besitzt, wird unter Manteltemperatur die Temperatur an der Oberfläche des Energiespeichers verstanden. Der Begriff "Manteltemperatur" ist im vorliegenden Dokument also synonym mit dem Begriff "Oberflächentemperatur". Die Oberflächen- beziehungsweise Manteltemperatur des Energiespeichers kann ohne hohen technischen Aufwand dadurch gewonnen werden, dass ein Sensor an der Außenseite des Energiespeichers angebracht wird.

In einem weiteren Schritt des Verfahrens zum Ermitteln der Kerntemperatur erfolgt ein Messen eines elektrischen Stroms durch den Energiespeicher. In der Regel wird der Energiespeicher von einem Gesamtstrom durchflossen. Dieser Gesamtstrom kann sich gegebenenfalls auch in Teilströme aufteilen. Für das Ermitteln der Kerntemperatur ist es lediglich wichtig festzulegen, welcher Strom herangezogen werden soll. Entweder ist es der Gesamtstrom, der gemessen wird, oder aber auch nur ein Teilstrom davon. Der gemessene Strom stellt einen Energietransport in den Energiespeicher dar, der nur zum Teil zum Ladungsaufbau bzw. Ladungsabbau dient. Insbesondere wird sich der Energiespeicher durch ohmsche Verluste erwärmen.

In einem anschließenden Schritt erfolgt ein Ermitteln der Kerntemperatur des Energiespeichers mit Hilfe eines thermischen Modells aus der gemessenen Manteltemperatur und dem gemessenen elektrischen Strom. Dieses thermische Modell wird üblicherweise nicht nur geometrische Gegebenheiten des Energiespeichers berücksichtigen, wie etwa die äußere Form, z.B. Zylinderform. Das thermische Modell wird in aller Regel auch materialspezifische Parameter aufweisen, die den individuellen Materialien des Energiespeichers Rechnung tragen. Ein Beispiel eines materialspezifischen Parameters ist die spezifische Wärmekapazität. Ein weiteres Beispiel wäre aber auch die Dichte oder die Wärmeleitfähigkeit. In dem thermischen Modell werden in aller Regel aber auch andere physikalische Parameter wie die Masse und der Zellinnenwiderstand berücksichtigt sowie etwaige geometrische Größen wie Volumen, Radius etc. Aus all diesen Größen, mindestens aber aus der gemessenen Manteltemperatur und dem gemessenen elektrischen Strom wird mittels des thermischen Modells die Kerntemperatur des Energiespeichers ermittelt beziehungsweise geschätzt.

In vorteilhafter Weise wird durch das erfindungsgemäße Verfahren also die für den Energiespeicher wichtige Kerntemperatur mittels eines Modells auf der Basis der Manteltemperatur gewonnen. Dies bedeutet, dass die Temperatur im Kern des Energiespeichers einfach dadurch gewonnen werden kann, dass die Temperatur am Mantel gemessen und der fließende Strom berücksichtigt wird. Dadurch ergibt sich ein sehr geringer Simulationsaufwand, der von einem verhältnismäßig kleinen Prozessor bewältigt werden kann.

Bei einer vorteilhaften Ausgestaltung des erfindungsgemäßen Verfahrens ist vorgesehen, dass der Energiespeicher die Form eines geraden Zylinders besitzt und die Kerntemperatur an einer Stelle einer Längsachse des Energiespeichers ermittelt wird. Insbesondere Lithium-Ionen-Akkus besitzen häufig die Form eines geraden Zylinders, da sie meist gewickelt sind. Der Kern dieses zylindrischen Energiespeichers befindet sich dann auf der Zylinder- beziehungsweise Längsachse. Wie oben bereits dargestellt wurde, muss sich der Kern aber nicht exakt im Zentrum des Energiespeichers, d.h. in der Mitte der Längsachse befinden, sondern er kann sich auch an einer anderen Stelle der Längsachse befinden. Die gerade Zylinderform des Energiespeichers hat den Vorteil, dass bekannte thermische Modelle für gerade Zylinder verwendet werden können. Derartige Modelle sind meist verhältnismäßig einfach und basieren auf analytischen Funktionen.

In einer speziellen Ausgestaltung besitzt der Energiespeicher die Form eines geraden Zylinders und die Kerntemperatur wird an einer Stelle einer Längsachse des Energiespeichers ermittelt. Zwar ist ein gerader Zylinder die meist übliche Form eines Zylinders, aber es sind auch schräge Zylinder denkbar, deren Zylinderachse einen von Null verschiedenen Winkel zur Normalen der Zylinderstirnseiten einnimmt. Auf diese Weise können gegebenenfalls auch schräg geschnittene zylindrische Energiespeicher in Bezug auf die Kerntemperatur modelliert werden.

In speziellen Weiterbildungen kann vorgesehen sein, dass der Energiespeicher die Form eines Kreiszylinders, eines elliptischen Zylinders oder eines Prismas, insbesondere eines Quaders, besitzt und die Kerntemperatur wird im geometrischen Zentrum des Energiespeichers ermittelt. Die Stirnflächen der jeweiligen Zylinder können also unterschiedliche Gestalt besitzen. Sie können nicht nur kreisrund oder elliptisch sein, sondern auch in beliebiger Weise mehreckig. Für die jeweilige Zylinderform ist ein entsprechendes thermisches Modell zu wählen.

Des Weiteren kann vorgesehen sein, dass der Energiespeicher in dem thermischen Modell als homogener Körper betrachtet wird. Beispielsweise wird der Energiespeicher als homogener Körper mit einer mittleren spezifischen Wärmekapazität beziehungsweise einer mittleren Wärmeleitfähigkeit betrachtet. Auch wenn der tatsächliche Energiespeicher beispielsweise aus einer Vielzahl von gewickelten Schichten besteht, welche aus verschiedensten Materialien gebildet sein können (z.B. Anode, Kathode, Elektrolyt, Separator, Stromableiter), kann für das thermische Modell aus Gründen der Vereinfachung ein homogener Körper angenommen werden. Diese Vereinfachung erübrigt es, jede einzelne Schicht beispielsweise als Hohlzylinder zu betrachten. Der Rechenaufwand bei der Modellierung wird entsprechend reduziert.

Insbesondere können für das thermische Modell eine mittlere Dichte und eine mittlere spezifische Wärmekapazität des Energiespeichers aus gewichteten Stoffeigenschaften des Energiespeichers gewonnen werden. Auch andere physikalische Parameter können mit entsprechenden Gewichten aus den Stoffeigenschaften einzelner Schichten des Energiespeichers für ein vereinfachtes Modell des Energiespeichers ermittelt werden.

Ein thermisches Modell kann grundsätzlich ein Wärmeleitungsmodell enthalten, mit dem beispielsweise die Wärmeabfuhr vom Zentrum des Energiespeichers nach außen simuliert wird. Darüber hinaus kann das thermische Modell aber auch ein Wärmeverlustmodell enthalten, mit dem ermittelt wird, welche Wärmeenergie aus einem Strom über ohmsche Verluste entsteht. Außerdem kann das thermische Modell auch eine oder mehrere Funktionen enthalten, die die Wärmeabgabe an die Umgebung beschreiben. Das thermische Modell ist aber nicht darauf begrenzt und kann auch weitere Funktionen enthalten.

Gemäß einer weiteren Ausgestaltung des erfindungsgemäßen Verfahrens für die Ermittlung der Kerntemperatur ist vorgesehen, dass mit dem thermischen Modell ausschließlich eine radiale Temperaturverteilung einschließlich der Kerntemperatur ermittelbar ist. Das thermische Modell ist also dahingehend vereinfacht, dass nur eine radiale Temperaturverteilung mit ihm ermittelt werden kann, die die Kerntemperatur einschließt. Mit dem thermischen Modell ist somit nicht eine räumliche Temperaturverteilung oder die Temperatur auf einer Fläche ermittelbar, sondern lediglich eine eindimensionale Temperaturverteilung. Speziell wenn die Außenkontur des Energiespeichers kreiszylinderförmig ist, ist eine solche radiale Temperaturverteilung sehr aussagekräftig, da eine entsprechende Punktsymmetrie der Temperaturverteilung vorliegt. Idealer Weise ist nämlich in einem (unendlich langen) kreiszylindrischen Energiespeicher die Temperatur unabhängig von der axialen Position und von der Winkelstellung. Gegebenenfalls kann die Temperaturverteilung von der Mittelachse des Energiespeichers bis zum Mantel reichen. Durch die Beschränkung des thermischen Modells ausschließlich auf die Simulation der radialen Temperaturverteilung ergibt sich ein sehr einfaches Modell, mit dem sich die Simulationsgeschwindigkeit gegenüber räumlichen Modellen weiter steigern lässt.

In einem weiteren Ausführungsbeispiel ist mit dem thermischen Modell sowohl eine radiale Temperaturverteilung als auch eine axiale Temperaturverteilung in dem Energiespeicher ermittelbar. In diesem Fall wird das thermische Modell dazu genutzt, beispielsweise eine räumliche Temperaturverteilung zu gewinnen. Dies ist insbesondere dann von Bedeutung, wenn in axialer Richtung eines z.B. zylindrischen Energiespeichers ein Temperaturgefälle zu erwarten ist. Dies ist üblicherweise schon deswegen der Fall, weil die Stirnflächen des Energiespeichers selbst Wärme abgeben und sich deswegen etwa bei einem kreiszylindrischen Energiespeicher an den Stirnflächen niedrigere Temperaturen einstellen werden als in dem Zentrum des Energiespeichers. Diese dreidimensionale Temperaturverteilung beinhaltet zwar auch die Kerntemperatur, ermöglicht aber auch Aussagen über die Temperatur in den Randbereichen des Energiespeichers in allen Raumrichtungen. Dies lässt sich beispielsweise nutzen, wenn eine Temperaturmessung nur an bestimmten, möglicherweise thermisch ungünstigen Stellen auf der Manteloberfläche möglich ist.

Bei einer besonders vorteilhaften Anwendung des erfindungsgemäßen Verfahrens wird die Manteltemperatur des Energiespeichers an einer Mantelstelle in axialer Mitte des Energiespeichers oder an einer heißesten Mantelstelle gemessen. In vielen Fällen kann von einem symmetrischen Energiespeicher ausgegangen werden, bei dem sich die höchste Temperatur im Fall des Stromflusses in der axialen Mitte des Energiespeichers einstellt. Daher ist es für das Modell von Vorteil, wenn auch die Manteltemperatur an einer axial mittigen Position gemessen wird. In anderen Fällen kann der Energiespeicher aber auch axial inhomogen gestaltet sein. In solchen Situationen ist es von Vorteil, die heißeste Mantelstelle empirisch zu ermitteln und dort die Manteltemperatur zu messen. Üblicherweise wird dann an der gleichen axialen Position die Kerntemperatur am höchsten sein. In diesem Fall sollte also versucht werden, beim Messen der Manteltemperatur diejenige Stelle an der Oberfläche des Energiespeichers zu finden, die auf die Position des Kernbereichs mit der höchsten Temperatur hindeutet.

Gemäß einem weiteren Ausführungsbeispiel wird in dem thermischen Modell der Energiespeicher mit einem einzigen RC-Glied simuliert. Wird ein thermisches Modell mit RC-Gliedern gebildet, so lassen sich auch komplexe Temperaturverläufe realitätsnah simulieren. Eine besondere Vereinfachung liegt nun darin, dass das Modell nur ein einziges RC-Glied aufweist. Das bedeutet, dass mit dem thermischen Modell nur eine einfache Exponentialfunktion simuliert wird. In den meisten Fällen reicht jedoch die Genauigkeit einer einfachen Exponentialfunktion für die Abschätzung der Temperaturverteilung aus. Erfolgt die thermische Simulation des Energiespeichers mit einem einzigen RC-Glied, so liegt ein sehr einfaches thermisches Modell vor, das einen minimalen Rechenaufwand erfordert.

Bei einer Weiterbildung des Verfahrens ist vorgesehen, dass in dem thermischen Modell eine Exponentialfunktion durch eine oder mehrere lineare Funktionen angenähert wird, die den Exponenten der Exponentialfunktion multipliziert mit einer Maximaltemperatur als Term aufweist/aufweisen. Die Exponentialfunktion wird also durch eine oder mehrere lineare Funktionen angenähert. Hierdurch wird der Rechenaufwand für das thermische Modell deutlich vermindert. Die Maximaltemperatur kann insbesondere eine Grenztemperatur darstellen, die sich bei einem spezifischen Lastfall einstellt. Beispielsweise ergibt sich bei einem bestimmten Ladestrom oder einem bestimmten Entladestrom nach einer Einschwingphase diese Grenztemperatur. Die Grenztemperaturbeziehungsweise Maximaltemperatur kann also einen thermischen Gleichgewichtszustand darstellen, der sich bei einem vorgegebenen Strom einstellt.

Somit kann auch ein Verfahren zum Steuern oder Regeln eines Betriebs eines Energiespeichers durch Ermitteln einer Kerntemperatur des Energiespeichers, wie es oben beschrieben wurde, bereitgestellt werden. Dabei wird der Betrieb des Energiespeichers in Abhängigkeit von der ermittelten Kerntemperatur gesteuert oder geregelt. Da die Kerntemperatur auf einfache Weise aus der Oberflächentemperatur beziehungsweise der Manteltemperatur gewonnen werden kann, ist es damit auch möglich, den Energiespeicher indirekt über die gemessene Manteltemperatur zu steuern beziehungsweise zu regeln. Dabei wird, wie es oben beschrieben wurde, die Kerntemperatur aus der Manteltemperatur geschätzt beziehungsweise hergeleitet und sodann als Parameter für das Steuern oder Regeln des Energiespeichers verwendet.

In einer Weiterbildung des Verfahrens zum Steuern oder Regeln wird eine Leistungsabgabe des Energiespeichers an einen Verbraucher oder ein Ladestrom oder eine Ladespannung des Energiespeichers in Abhängigkeit von der Kerntemperatur gesteuert. Es wird also die Entladeleistung des Energiespeichers oder aber der Ladevorgang des Energiespeichers mittels der Kerntemperatur gesteuert beziehungsweise geregelt. Dies hat den Vorteil, dass Alterungsprozesse des Energiespeichers, die sich aus Ladevorgängen und Entladevorgängen ergeben, anhand der jeweiligen Kerntemperatur des Energiespeichers optimiert werden können. Da nämlich die Kerntemperatur beziehungsweise die Temperaturverteilung unter den aktuellen Konditionen (z.B. aktuelle Gesamtspannung des Energiespeichers und aktueller Entladestrom) bekannt ist, ist auch bekannt, an welcher Stelle (z.B. Elektrode, Separator oder dergleichen) eine kritische Temperatur vorherrscht. Aufgrund entsprechender Temperaturvorgaben kann der Betrieb des Energiespeichers (z.B. das Entladen) entsprechend gesteuert oder geregelt werden. So lässt sich beispielsweise der Entladevorgang rechtzeitig stoppen oder reduzieren, wenn oder bevor eine vorbestimmte Temperatur an einer gewissen Stelle erreicht wird. Somit kann der Betrieb des Energiespeichers automatisch so angepasst werden, dass gewisse Maximaltemperaturen nicht überschritten werden. Ähnliches kann auch für Minimaltemperaturen gelten.

Speziell kann vorgesehen sein, dass eine Leistungsabgabe des Energiespeichers an einen Verbraucher oder ein Ladestrom oder eine Ladespannung des Energiespeichers in Abhängigkeit von der Kerntemperatur gesteuert wird. Dies bedeutet nicht nur, dass der Energiespeicher selbst derart geregelt oder gesteuert werden kann, sondern auch der entsprechende Verbraucher oder das Ladegerät. Somit kann aufgrund der innerhalb des Energiespeichers ermittelten Kerntemperatur ein Steuer- beziehungsweise Regelsignal für eine externe Einrichtung außerhalb des Energiespeichers bereitgestellt werden.

Darüber hinaus wird die oben genannte Aufgabe auch durch einen Energiespeicher mit einer Steuereinrichtung zum Durchführen eines Verfahrens, wie es oben geschildert wurde, gelöst. Ein derartiger Energiespeicher beziehungsweise dessen Steuereinrichtung kann hinsichtlich der Funktionen so weitergebildet werden wie das oben beschriebene Verfahren. Insofern ergeben sich sinngemäß die gleichen Vorteile für den Energiespeicher wie für das Verfahren.

Speziell kann der Energiespeicher mehrere Zellen aufweisen, von denen jede einzeln durch das gleiche thermische Modell modelliert wird. Es wird also in diesem Fall für jede einzelne Zelle des Energiespeichers individuell die jeweilige Kerntemperatur ermittelt, indem die jeweiligen Manteltemperatur der Zelle und der Strom durch diese Zelle gemessen wird und aus diesen Messgrößen über das thermische Modell die jeweiligen Kerntemperatur ermittelt wird. Es muss aber nicht für jede einzelne Zelle die Kerntemperatur ermittelt werden. Vielmehr genügt es unter Umständen in einem Zellverbund repräsentativ für eine spezielle Zelle die Kerntemperatur zu ermitteln und mehrere Zellen davon abhängig zu steuern beziehungsweise zu regeln.

In einer weiteren Ausgestaltung des erfindungsgemäßen Verfahrens ist vorgesehen, dass bei dem Ermitteln der jeweiligen Kerntemperatur eine numerische Simulation durchgeführt wird. Eine derartige numerische Simulation hat in der Regel Vorteile gegenüber einer analytischen Lösung. Insbesondere können dadurch Echtzeitbedingungen eingehalten werden, bei denen beispielsweise Schaltprozesse in Bruchteilen von Sekunden (insbesondere 0,1 s bis 1 s) erfolgen müssen. Derartige numerische Simulationen können in einem Managementsystem des Energiespeichers ausgeführt werden. Insbesondere können entsprechende Prozessoren dafür ausgelegt sein.

Speziell können ein oder mehrere Parameter für die numerische Simulation durch künstliche Intelligenz anhand von Temperaturmessungen ermittelt werden. Die künstliche Intelligenz kann beispielsweise auf einem neuronalen Netzwerk, einer Support-Vektor-Maschine, einem Entscheidungsbaum, einem Bayes'schen Netzwerk, einem kinetischen Algorithmus und/oder Assoziationsregeln oder dergleichen basieren. Das neuronale Netzwerk oder die anderen Algorithmen können für die numerische Simulation entsprechend trainiert werden. Somit können beispielsweise in einem Labor auch im Inneren des Energiespeichers Temperaturmessungen durchgeführt werden, die für das Trainieren der künstlichen Intelligenz verwendet werden. Die im Labor trainierte künstliche Intelligenz kann anschließend für die Simulation verwendet werden, um in kürzester Zeit die gesuchte Kerntemperatur im Energiespeicher während des Betriebs des Energiespeichers zu ermitteln. Die numerische Simulation, die durch die künstliche Intelligenz durchgeführt wird, kann somit durch Temperaturmessungen insbesondere im Labor trainiert werden, wobei entsprechende Parameter beziehungsweise Gewichte der künstlichen Intelligenz gewonnen werden.

Wie oben bereits angedeutet wurde, kann ein Energiespeicher eine Steuereinrichtung aufweisen, um ein oben geschildertes Verfahren durchzuführen. Speziell kann also ein Lithium-Ionen-Akku eine spezifische Steuerungs- beziehungsweise Überwachungselektronik aufweisen. Diese Steuereinrichtung kann Teil eines sogenannten Batteriemanagementsystems sein, das als integrierte Elektronik in dem Energiespeicher vorgesehen ist.

Erfindungsgemäß wird insbesondere ein Elektrowerkzeug bereitgestellt, das einen oben genannten Energiespeicher mit der Steuereinrichtung aufweist, um das bzw. die oben genannten Verfahren auszuführen. Derartige akkubetriebene Elektrowerkzeuge sind beispielsweise Akkuschrauber, Akkubohrer, Akku-Kreissägen, Akku-Gartengeräte und dergleichen.

Die oben geschilderte Aufgabe wird erfindungsgemäß auch gelöst durch ein Computerprogrammprodukt, das Befehle umfasst, die bewirken, dass der oben genannte Energiespeicher oder das oben genannte Elektrowerkzeug die ebenfalls oben geschilderten Verfahrensschritte ausführt. Ein derartiges Computerprogrammprodukt kann ein Speichermedium umfassen, auf dem ein korrespondierendes Computerprogramm mit den genannten Befehlen gespeichert ist. Ein Speichermedium kann beispielsweise eine DVD, ein RAM, ein SSD-Speicher oder jeder andere geeignete Speicher für Computerprogramme sein.

Die oben im Zusammenhang mit dem erfindungsgemäßen Verfahren geschilderten Vorteile und Variationsmöglichkeiten können analog auch bei dem Energiespeicher beziehungsweise Elektrowerkzeug realisiert werden. Dies gilt gleichermaßen für entsprechende Kombinationen von Merkmalen.

Die vorliegende Erfindung wird nun anhand der beigefügten Zeichnungen näher erläutert, in denen zeigen:

Fig. 1 ein Modell eines zylindrischen Energiespeichers zur Ermittlung der Kerntemperatur;

Fig. 2 einen Akkupack für ein Elektrowerkzeug oder Gartengerät;

Fig. 3 ein Elektrowerkzeug und

Fig. 4 einen schematischen Verfahrensablauf eines Ausführungsbeispiels.

Die nachfolgend näher geschilderten Ausführungsbeispiele stellen bevorzugte Ausführungsformen der vorliegenden Erfindung dar.

Die Einlastung von thermischer Energie (Wärme) in einen Energiespeicher ergibt sich physikalisch rechnerisch insbesondere durch den Stromfluss über die beiden Innenwiderstände der dielektrischen und elektrochemischen Kapazitäten. Die dielektrische Kapazität ergibt sich aus dem Schichtaufbau und die elektrochemische Kapazität aus der Ladungsspeicherung in der elektrochemischen Struktur. Räumlich erfolgt der Energieeintrag in Abhängigkeit von dem Schichtaufbau des Energiespeichers. So erfolgt der Energieeintrag bei einer gewickelten Zelle anders als bei einer gestapelten Zelle. In der Regel wird der Energieeintrag verteilt über die einzelnen Schichten in die Zelle stattfinden. Dies gilt zumindest so lange, wie sich ein homogener Stromfluss über die Elektrodenbahnen und deren Oberflächen ausbildet. Kommt es zu inhomogenen Strompfaden bei sehr hohen Strombelastungen, so erfolgt eine erhöhte Wärmeabgabe punktuell entlang dieser Strompfade.

Bei einer gewickelten Zelle verteilt sich die eingetragene Wärmemenge durch eine radiale Wärmeleitung vom Zentrum der Zelle hin zum radialen Abschluss der Zelle, den Zellmantel, und über eine axiale Wärmeleitung vom Zentrum zu den beiden Polkappen der Zelle. Die Wärme wird von allen Masseelementen der Zelle über das Zellvolumen hinweg entsprechend ihrer Wärmekapazität gespeichert. Derartige Masseelemente sind insbesondere die Elektroden, der Elektrolyt, der Separator, das Gehäuse und die Strom leiter.

Trotzdem kann für ein in den meisten Fällen hinreichend genaues Modell angenommen werden, dass sich die höchste Temperatur eines Energiespeichers bei Stromfluss in dessen Kern einstellen wird. Bei einem zylindrischen Energiespeicher wird dies auf der Zylinderlängsachse sein. Dabei kann in einer vereinfachten Annahme davon ausgegangen werden, das die Wärme mittels Strom im Zentrum beziehungsweise an der Achse eingetragen wird und nach außen insbesondere in radialer Richtung abgeleitet wird. An der Oberfläche des Energiespeichers, z.B. dem Zellmantel kann eine entsprechende Oberflächen- beziehungsweise Manteltemperatur gemessen werden. Diese lässt dann Rückschlüsse auf die Kerntemperatur des Energiespeichers in Abhängigkeit von dem fließenden Strom zu.

Für eine solide Steuerung z.B. der Lithium-Ionen-Zelle, insbesondere in dynamischen Situationen (quasi-stationäre Betriebszustände), sind die situativen Temperaturen an allen Raumpunkten der Zelle zu berücksichtigen. Verwendet man lediglich einen außenliegenden Temperaturmesspunkt, so ist für den sicheren Betrieb der Zelle stets genügend kalorischer Puffer vorzusehen und gleichzeitig die Strommenge zu begrenzen, damit in Kernbereichen der Zelle die Temperaturen nicht über kritische Schwellwerte steigen. Eine Zelle kann auf diese Art und Weise ihre tatsächliche elektrochemische Leistungsfähigkeit nicht ausspielen. Hierfür wird erfindungsgemäß ein einfaches (numerisches) Simulationsmodell bereitgestellt, welches vorzugsweise zeitlich hochaufgelöst die tatsächliche Kerntemperatur beziehungsweise Temperatursituation in der Zelle simuliert und damit ein sicheres, rechtzeitiges Abschalten anliegender Verbraucher ermöglicht, gleichzeitig diesen aber eine maximale Leistung aus der Zelle heraus zur Verfügung stellt.

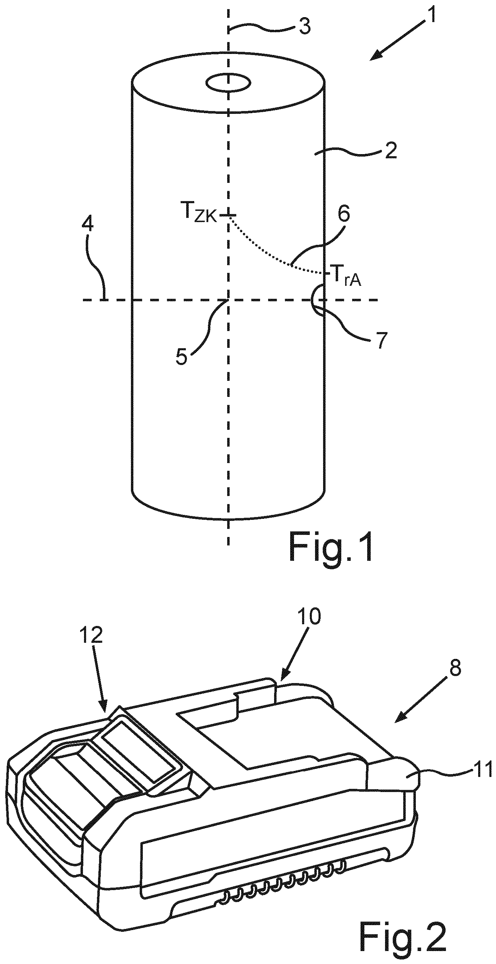

In einem konkreten Beispiel gemäß Fig. 1 wird angenommen, dass es sich bei dem Energiespeicher um eine gewickelte, zylindrische Zelle handelt. Eine derartige Zelle 1 kann eine Litihum-Ionen-Akkuzelle sein. Die Zelle 1 besitzt eine Mantelfläche 2, die dem Zylindermantel entspricht. Sie stellt eine Außenfläche der Zelle 1 beziehungsweise des Energiespeichers dar. Alternativ kann es sich bei dem Energiespeicher 1 aber auch beispielsweise um einen quaderförmigen, geschichteten Speicher handeln. Die Außenseiten des Quaders stellen in diesem Fall die Oberfläche des Energiespeichers dar. Die Zellchemie ist grundsätzlich beliebig.

In dem konkreten Beispiel von Fig. 1 besitzt die kreiszylinderförmige Zelle 1 eine Zylinderbeziehungsweise Längsachse 3. Es wird davon ausgegangen, dass sich die höchste Temperatur bei Stromfluss auf diese Achse 3 ergeben wird. Weiterhin kann angenommen werden, dass sich die höchste Temperatur in der axialen Mitte, die durch die Mittellinie 4 senkrecht zur Längsachse 3 in der Fig. eingezeichnet ist, ergibt. Der Schnittpunkt der Mittellinie 4 mit der Längsachse 3 stellt das Zentrum beziehungsweise den Zellkern 5 dar. Gegebenenfalls kann der Zellkern auch ein räumlicher Bereich um das Zentrum sein, der etwa 10 Prozent der Ausdehnung in jeder Raumrichtung des Energiespeichers darstellt.

In Fig. 1 ist schematisch eine radiale Temperaturverteilung 6 eingezeichnet, die sich auf der Mittellinie 4 ausgehend von der Längsachse 3 bis zur Mantelfläche 2 ergibt. Diese Temperaturverteilung 6 beinhaltet eine Kerntemperatur $T_{ZK}$ und an der Mantelfläche 2 eine Oberflächentemperatur $T_{rA}$. Dazwischen ergibt sich näherungsweise ein exponentielle Abfall.

Zur Messung der Temperatur kann an der Mantelfläche 2 ein Temperatursensor 7 vorgesehen sein. An der Ober- beziehungsweise Mantelfläche 2 kann die Temperatur einfacher gemessen werden als beispielsweise auf der Längsachse 3 der Zelle 1.

Ziel der thermischen Simulation ist die Ermittlung der Zellkerntemperatur $T_{ZK}$. Es wird, wie oben bereits dargestellt wurde, angenommen, dass die Temperatur auf der Längsachse 3 der beispielsweise zylinderförmigen Zelle 1 am höchsten ist. Um Schäden an der Zelle 1 zu vermeiden, dient die höchste Temperatur in der Zelle 1 als limitierter Faktor bei Lade- beziehungsweise Entladevorgängen. Die Ermittlung der Zellkerntemperatur $T_{ZK}$ erfolgt beispielsweise aus den messbaren Parameterwerten:

- Strom (Betrag der Lade- beziehungsweise Entladeströme)
- Zellmanteltemperatur $T_{rA}$
- Zellimpedanz

Dabei kann die Zellimpedanz auch als zumindest zeitlich vorübergehend feste Größe vorgegeben sein. Die Zellimpedanz kann aber auch indirekt durch Konstanten in die Zellkerntemperaturermittlung eingehen.

Bei der Simulation mit Hilfe eines thermischen Modells können mehrere Annahmen und Vereinfachungen vorgenommen werden, um eine rasche Berechnung mit begrenzten Ressourcen gewährleisten zu können. In dem nachfolgenden Ausführungsbeispiel erfolgt die Simulation mit Hilfe von drei optionalen Schritten a) bis c). Diese Aufteilung der Schritte stellt eine von mehreren Möglichkeiten dar.

Zur Ermittlung der Zellkerntemperatur kann folgende Vorgehensweise als Rekursion angewandt werden. Die Herleitung der aufgeführten Gleichungen erfolgt weiter unten.

a) Zunächst wird in einem ersten Schritt die Temperaturverteilung über dem Zellradius ermittelt. Hierzu wird eine Wärmeentwicklung angenommen, die durch eine statische Verlustleistung innerhalb einer Batteriezelle in einem diabatischen System hervorgerufen wird. Diese Wärmeentwicklung führt zu einem in Abhängigkeit von der Verlustleistung und den Stoffeigenschaften stehenden Temperaturgradienten über den Zellradius. Dieser Temperaturgradient beziehungsweise Temperaturverlauf stellt sich zwischen Zellkern und Zelloberfläche für einen bestimmten Lastfall fest ein, wenn sich das System in einem thermischen Gleichgewicht befindet. In diesem thermischen Gleichgewicht entspricht die Zellkerntemperatur $T_{ZK}$ der Maximaltemperatur

$$T_{Max} = T_{rA} + \frac{P}{V*4\lambda} * r^2 \qquad [6]$$

Mit:

$T_{Max}$ = Maximale Temperatur Zellkern in [°C]
$T_{rA}$ = Temperatur an der Zelloberfläche in [°C]

P = Leistung in [W]
V = Volumen in [m3]
λ = Wärmeleitfähigkeit in [W/(m*K)]
r = Radius

b) In einem weiteren Schritt wir die Zelltemperatur in Abhängigkeit von der geleisteten Arbeit ermittelt. Dabei wird berücksichtigt, dass in einem angenommenen adiabatischen System die gemessene Verlustleistung zu einer zeitabhängigen, dynamischen und gleichmäßigen Erwärmung der Batteriezelle führt. Die Betrachtung der Temperaturentwicklung der Zelloberfläche unter Berücksichtigung der gemessenen Verlustleistung und der Zellstoffeigenschaften liefert Auskunft über die tatsächliche Wärmeabgabe der Batteriezelle an die Umgebung. Das Verhältnis $K_P$ aus Temperaturentwicklung der Zelloberfläche (Differenz der Rekursionsschritte: $T_{rA}-T_{rA-1}$) zu der dynamischen Zellerwärmung (proportional zur Leistung $I^2*R$) beeinflusst den simulierten Temperaturanstieg des Zellkernes. Von der erzeugten Wärme wird also ein Teil an die Umgebung abgegeben und der Rest bleibt in der Zelle. Demnach ergibt sich:

$$K_P = 1 - \frac{(T_{rA}-T_{rA-1})*c*m}{I^2*R*10^{-3}} \qquad [9]$$

Mit:

$k_p$ = Verhältnis
c = Spezifische Wärmekapazität in [J/K]
m = Masse in [kg]
I = Strom in [A]
R = Zellinnenwiderstand in [Ohm]

c) In einem dritten Schritt wird die Angleichung der Zellkerntemperatur ermittelt. Hierzu wird in der Simulation für die Batteriezelle ein Ersatzschaltbild aus RC-Gliedern (vorzugsweise einem einzigen RC-Glied) verwendet. Das heißt, die Temperaturentwicklung des Zellkerns verhält sich analog zu der Exponentialfunktion der Spannung in RC-Gliedern. Der maximale Temperaturwert des Zellkernes entspricht der Zellmanteltemperatur plus der in a) berechneten maximalen Temperaturdifferenz. Die Zeitkonstante der Exponentialfunktion ergibt sich aus Wärmekapazität und Wärmewiderstand in Abhängigkeit des in b) ermittelten Verhältnisses aus Temperaturentwicklung der Zelloberfläche zu der dynamischen Zellerwärmung in einem adiabatischen System.

Erwärmt sich die Zelle aufgrund erhöhter Stromstärke, so gilt bei $T_{Max} > T_{ZK}$:

$$T_{ZK_n} = T_{ZK_{n-1}} + \frac{(T_{Max}-T_{ZK_{n-1}})*K1*K_P}{c*m} \qquad [10]$$

Kühlt sich hingegen die Zelle bei Reduktion des Stroms ab, so gilt bei $T_{Max} < T_{ZK}$:

$$T_{ZK_n} = T_{ZK_{n-1}} - \frac{(T_{ZK_{n-1}}-T_{Max})*K1}{c*m} \qquad [12]$$

Mit:

$T_{ZKn}$ = Berechnete Temperatur im Zellkern in [°C] im Rekursionsschritt n
K1 = System konstante

Nachfolgend werden die oben angeführten Gleichungen hergeleitet.
In dem ersten Schritt a) bei dem die Temperaturverteilung über dem Zellradius ermittelt wird, werden die Annahmen getroffen:

- Die axiale Temperaturverteilung wird bei der Simulation vorerst nicht berücksichtigt. Im Folgenden wird ausschließlich die radiale Temperaturverteilung betrachtet. Dabei kann ein Temperatursensor zentral in axialer Mitte oder am heißesten Punkt des Mantels vorgesehen sein.

- Für die radiale Wärmeleitfähigkeit werden die spiralförmigen Schichten der Spule hierzu vereinfachend als konzentrische Ringschalen betrachtet. Für die Ermittlung der Zell-Wärmeleitfähigkeit wird die Zelle als homogener Körper mit den entsprechenden Stoffeigenschaften angesehen.
- Dichte p und spezifische Wärmekapazität c der Zelle werden durch die gewichteten mittleren Stoffeigenschaften der Zellbestandteile beschrieben. Dabei wird die Dichte als volumenspezifische Größe auf die Volumenanteile bezogen, die massenspezifische Wärmekapazität wird hingegen massenanteilig gemittelt.

Die Wärmeleitfähigkeit der Zelle lässt sich wie folgt darstellen:

$$\lambda_r = \frac{D}{\sum \frac{d_n}{\lambda_n}} \qquad [1]$$

$\lambda_r$ = radiale Wärmeleitfähigkeit

$D$ = summierte Schichtdicke der Materialschichten

Es lässt sich folgende Wärmeleitungsgleichung aufstellen:

$$s = cp * \frac{\partial T}{\partial t} + \vec{\nabla} * \vec{j} \qquad [2]$$

Mit:

| | | |
|---|---|---|
| s | = Wärmequelldichte: | $\frac{W}{m^3}$ |
| c | = Wärmekapazität: | $\frac{J}{kg*K}$ |
| p | = Dichte: | $\frac{kg}{m^3}$ |
| T | = Temperatur: | K |
| t | = Zeit: | s |
| $\vec{j}$ | = Wärmestromdichte: | $\frac{W}{m^2}$ |

Mit dem Wärmeleitungsgesetz nach Fourier:

$$\vec{j} = -\lambda * \vec{\nabla} * T \qquad \text{und } \lambda = \text{Wärmeleitfähigkeit } \frac{W}{mK} \qquad [3]$$

Für zylindrische Zellen bieten sich Zylinderkoordinaten an:

$$s = c * p * \frac{\partial T}{\partial t} + \frac{1}{r} * \frac{\partial}{\partial r} * (r * j_r) + \frac{1}{r} * \frac{\partial}{\partial \varphi} * j_\varphi + \frac{\partial}{\partial z} * j_z$$

Annahme: Da in Umfangsrichtung kein Wärmestrom erwartet wird, und der axiale Wärmestrom vernachlässigt wird, können $j_\varphi$ und $j_z$ gleich null gesetzt werden. Daraus folgt:

$$s = c * p * \frac{\partial T}{\partial t} + \frac{1}{r} * \frac{\partial}{\partial r}(r * j_r) \qquad [4]$$

Da in diesem Fall die leistungsabhängige Temperaturverteilung über den Zellradius gesucht wird, kann dieser Fall als stationär betrachtet werden.

Im stationären Fall gilt $\frac{\partial T}{\partial t} = 0$:

$$s * r = \frac{\partial}{\partial r}(r * j)$$

Integration über die radiale Ausdehnung des Zylinders:

$$\frac{s * r^2}{2} + C = r * j$$

(C=Integrationskonstante)

$$\frac{s * r}{2} + \frac{C}{r} = j$$

Annahme: Zur Berechnung der Integrationskonstante C wird für einen Hohlzylinder angenommen, dass die Dichte der Wärmeabgabe am Innenradius ri gleich minus der am Außenradius ra ist.

$$\frac{s * ri}{2} + \frac{C}{ri} = -\frac{s * ra}{2} + \frac{C}{ra}$$

$$C = -\frac{s}{2} * \frac{(ri^2 * ra) + (ra^2 * ri)}{ra + ri}$$

Für einen Vollzylinder ist der Innenradius = 0. Daraus folgt für C = 0.

$$j = \frac{s * r}{2} \qquad [5]$$

Für die Wärmestromdichte am Außenrand gilt j=$j_A$ und r=$r_A$

$$s = \frac{2j_A}{r_A}$$

Nach Fourier [3] gilt für die stationäre Betrachtung $\frac{\partial T}{\partial t} = 0$ in der auf die radiale Dimension begrenzten Raumkoordinate (wieder für den Gradient der Zylinderpolarkoordinaten):

$$\vec{j} = -\lambda * \frac{dT}{dr} * \vec{e_r}$$

$$\vec{j} = j_r * \vec{e_r} = j * \vec{e_r}$$

wobei gilt:

$$j = -\lambda * \frac{dT}{dr}$$

Einsetzen in [5]:

$$\frac{dT}{dr} = -\frac{s * r}{2 * \lambda}$$

Mit s und $\lambda$ konstant und über den Radius r integriert folgt:

$$T(r) = -\frac{s}{2*\lambda} * \int dr * r \qquad => \qquad T(r) = -\frac{s*r^2}{4*\lambda} + C$$

Die Integrationskonstante C ist in diesem Fall die Außentemperatur T=$T_{RA}$ (r=$R_A$). Damit kann das stationäre Temperaturfeld der Zelle durch folgende Formel beschrieben werden:

$$T(r) = T_{rA} + \frac{s}{4\lambda} * (r_A{}^2 - r^2)$$

Mit Wärmequelldichte s = Wärmeerzeugungsleistung P / Volumen ergibt sich:

$$T(r) = T_{rA} + \frac{P}{V * 4\lambda} * (r_A{}^2 - r^2)$$

T(r) entspricht hier der maximal möglichen Temperatur in Abhängigkeit der Verlustleistung P im Zellinneren. $T_{rA}$ entspricht der Manteltemperatur. Für die maximale Zellkerntemperatur $T_{MAX}$ bei r=0 ergibt sich somit:

$$T_{Max} = T_{rA} + \frac{P}{V*4\lambda} * r_A^2 \qquad\qquad [6]$$

Nachfolgend wird für den Schritt d) die Gleichung [9] zur Ermittlung der Zelltemperatur in Abhängigkeit von der geleisteten Arbeit hergeleitet.
Für die Betrachtung werden ausschließlich die ohmschen Verluste herangezogen. Reversible Verluste wie Reaktionsentropie, Mischungsenthalpie oder Nebenreaktionen bleiben unberücksichtigt.
Berechnung des Zell-Innenwiderstandes R:

$$R = \frac{U_{t1} - U_{t2}}{I_{t1} - I_{t2}}$$

Mit:

$U_{t1/t2}$    = Klemmspannung zum Zeitpunkt t1 und t2
$I_{t1/t2}$    = Strombetrag zum Zeitpunkt t1 und t2

Die Zelle wird als eine Kombination mehrerer RC-Glieder betrachtet. Aus Gründen der Rechenleistung wird versucht die Simulation mit nur einem einzigen RC-Glied umzusetzen (erster wesentlicher Näherungsschritt):

$$\Delta T_{(t)} = P * R_{th} * \left(1 - e^{-\frac{t}{\tau}}\right)$$

Mit:

$\Delta T_{(t)}$ = Temperaturänderung des Zellkernes in Abhängigkeit der Zeit
$P$ = Verlustleistung
$R_{th}$ = Thermischer Widerstand der Zelle
$t$ = Zeit
$\tau$ = Zeitkonstante

$$R_{th} = \frac{\Delta T_{Max}}{P} \quad / \qquad \tau = R_{th} * C \quad / \qquad C = c * m$$

$$\Rightarrow \quad \Delta T_{(t)} = \Delta T_{Max} * \left(1 - e^{\frac{-t*P}{\Delta T_{Max}*c*m}}\right)$$

Mit:

$\Delta T_{Max}$ = $T_{max} - T_{rA}$
$C$ = Wärmekapazität
$\Delta T$ = Temperaturänderung

Für homogene Körper, wie in diesem Fall angenommen gilt: $C = c * m$
Mit:

$c$ = spezifische Wärmekapazität
$m$ = Masse

Um dynamisch auf Lastsprünge reagieren zu können, wird die Berechnung in konstanten Zeitintervallen für $T_{Max} - T_{ZK}$ in Abhängigkeit der Leistung P durchgeführt.

$$t = \frac{(T_{Max} - T_{ZK}) * K1}{P}$$

Mit:

$T_{ZK}$ = Temperatur im Zellkern
$K1$ = System konstante 1

$$T_{ZK_n} = T_{ZK_{n-1}} + \Delta T_{Max} * \left(1 - e^{\frac{-(T_{Max}-T_{ZK_{n-1}})*K1}{\Delta T_{Max}*c*m}}\right) \qquad [7]$$

Im ersten Durchlauf der Berechnung ist $T_{ZK_{n-1}} = T_{rA}$
Durch die Berechnung in konstanten Zeitintervallen kann für entsprechend kleine Schritte auf die e-Funktion verzichtet werden (zweiter wesentlicher Näherungsschritt) und es folgt:

$$T_{ZK_n} = T_{ZK_{n-1}} + \frac{(T_{Max}-T_{ZK_{n-1}})*K1}{c*m} \qquad [8]$$

Um die Wärmeabgabe an die Umgebung zu berücksichtigen, wird die diabatische Wärmeentwicklung des Zellmantels mit der theoretischen adiabatischen Wärmeentwicklung der Zelle verglichen.

Wärmeentwicklung des Zellmantels aufeinanderfolgender Berechnungen:

$$T_{rA} - T_{rA-1}$$

Theoretische adiabatische Wärmeentwicklung der Zelle pro Zeiteinheit t = 1 ms:

$$\Delta T = \frac{I^2 * R * 0,001}{c * m}$$

Anteil der zur Erwärmung des Zellkernes verbleibenden Leistung KP

$$K_P = 1 - \frac{(T_{rA} - T_{rA-1}) * c * m}{I^2 * R * 10^{-3}} \qquad [9]$$

$$\Rightarrow \quad T_{ZK_n} = T_{ZK_{n-1}} + \frac{(T_{Max} - T_{ZK_{n-1}}) * K1 * K_P}{c * m} \qquad [10]$$

Diese Berechnung wird durchgeführt, wenn bei einer Erwärmung der Zelle gilt:

$$T_{Max} > T_{ZK}$$

Die Gleichungen [10] und [12] in Schritt c) für die Ermittlung der Angleichung der Zellkerntemperatur können wie folgt hergeleitet werden:
Die "Zellkerntemperatur" steigt allenfalls bis zur "maximalen Zellkerntemperatur". Sinkt die "maximale Temperatur" aufgrund einer geringeren Verlustleistung unter die Zellkerntemperatur tritt ein Abkühleffekt im Zellkern auf.
Der Temperaturabfall der Zelle verläuft wie oben beschrieben analog dem Spannungsabfall eines RC-Glieds. Dieser berechnet sich wie folgt:

$$\Delta T_{(t)} = \Delta T_{Max} * (1 - e^{\frac{-t}{\tau}})$$

Mit:

$$\Delta T_{Max} = T_{ZK-Erwärmung} - T_{Max}$$

$T_{ZK\text{-}Erwärmung}$ = Zellkerntemperatur bei der Erwärmung. Dieser Wert bleibt während des Abkühlvorgangs konstant.

$$\Delta T_{(t)} = \Delta T_{Max} * (1 - e^{\frac{-(T_{ZK} - T_{Max}) * K1}{\Delta T_{Max} * c * m}}) \qquad [11]$$

Wie in [8] beschrieben entfällt die e-Funktion und es folgt:

$$T_{ZK_n} = T_{ZK_{n-1}} - \frac{(T_{ZK_{n-1}} - T_{Max}) * K1}{c * m} \qquad [12]$$

Diese Berechnung wird durchgeführt, wenn bei einer Abkühlung der Zelle gilt:

$$T_{Max} < T_{ZK}$$

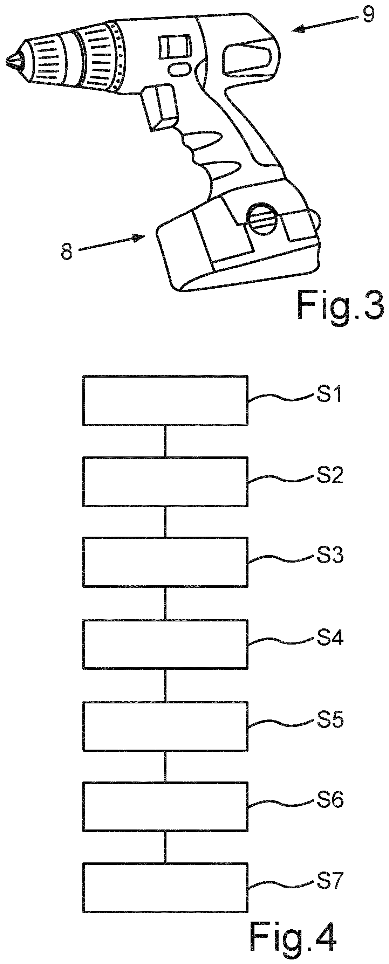

Fig. 2 zeigt einen Akkupack 8, der beispielsweise für ein Elektrowerkzeug 9 (vgl. Fig. 3) wie etwa einen Akkuschrauber oder ein elektrisches Gartengerät verwendet werden kann. Er besitzt eine Aufnahme 10, mit der er an das jeweilige Elektrowerkzeug 9 angesteckt werden kann. Im Inneren seines Gehäuses 11 befinden sich beispielsweise mehrere zylindrische Energiespeicher 1. Bei jedem einzelnen Energiespeicher 1 kann es sich etwa um eine gewickelte Lithium-Ionen-Zelle handeln. Das jeweils zugehörige thermische Modell kann in seiner geometrischen Ausgestaltung demjenigen von Fig. 1 gleichen.

In den Akkupack kann auch ein Batteriemanagementsystem integriert sein, das eine Schnittstelle 12 für einen Bediener besitzt. Beispielsweise kann diese Schnittstelle 12 den Ladezustand des Akkupacks 8 anzeigen oder eine Bedienmöglichkeit realisieren.

Das Batteriemanagementsystem kann eine geeignete Sensorik zur Erfassung eines Ladestroms, eines Entladestroms, einer Zellspannung, einer Gesamtspannung des Akkupacks, einer Temperatur einer oder mehrerer Zellen des Energiespeichers und/oder dergleichen aufweisen. Damit können einer oder mehrere der oben genannten Gruppe von Parametern erfasst und gegebenenfalls weiterverarbeitet werden. Insbesondere können so auch Änderungen der Zellspannung oder der Gesamtspannung sowie Änderungen des Ladestroms und Änderungen des Entladestroms ermittelt werden. Ein geeignetes Temperaturmodell auf der Basis der geometrischen Struktur, wie sie etwa in Fig. 1 dargestellt ist, erlaubt es dann, eine Kerntemperatur innerhalb jedes Energiespeichers oder jeder Zelle zu ermitteln. Das Temperaturmodell des Batteriemanagementsystems kann entsprechend den aktuellen Betriebsparametern eine Kerntemperatur liefern, welche zum Steuern des Betriebs des Energiespeichers und/oder eines mit dem Energiespeicher betriebenen Elektrogeräts genutzt werden kann.

Fig. 4 gibt schematisch einen Verfahrensablauf wieder, gemäß dem ein Elektrogerät betrieben werden kann. Dabei sind ein wesentlicher Bestandteil diejenigen Verfahrensschritte, die zur Ermittlung der Kerntemperatur dienen.

In einem ersten Schritt S1 erfolgt das Messen einer Manteltemperatur des Energiespeichers. Dieses Messen erfolgt beispielsweise mittels eines Temperatursensors an der Außenseite eines kreiszylindrischen Energiespeichers. Der Sensor kann in axialer Mitte oder aber auch beispielsweise an einem empirisch ermittelten heißesten Punkt an der Manteloberfläche platziert werden.

In einem zweiten Schritt S2 erfolgt das Messen des Stroms durch den Energiespeicher. Dabei kann es sich um einen Ladestrom oder um einen Entladestrom handeln. Beide Ströme bewirken jeweils eine Erwärmung des Energiespeichers beziehungsweise der Zelle.

In einem dritten Schritt S3, der optional durchgeführt werden kann, wird eine Maximaltemperatur ermittelt, die sich in einem thermischen Gleichgewichtszustand im Zellkern einstellt. In einem weiteren optionalen Schritt S4 kann eine stromabhängige relative Erwärmung ermittelt werden.

In einem fünften Schritt S5 wird die Kerntemperatur zumindest in Abhängigkeit von der gemessenen Manteltemperatur und dem gemessenen Strom ermittelt. Gegebenenfalls erfolgt dies auf der Basis der in den Schritten S3 und S4 ermittelten Manteltemperatur und ermittelten stromabhängigen relativen Erwärmung.

In einem weiteren optionalen Schritt S6 kann eine Temperaturverteilung innerhalb des Energiespeichers ermittelt werden. Dabei kann es sich beispielsweise um die radiale Temperaturverteilung in einer zylindrischen Zelle handeln. Gegebenenfalls wird auch eine axiale Temperaturverteilung ermittelt. Teil dieser Temperaturverteilung ist immer die Kerntemperatur im Kern des Energiespeichers.

Schließlich erfolgt in einem siebten Schritt S7 ein Steuern beziehungsweise Regeln des Betriebs des Energiespeichers in Abhängigkeit von der ermittelten Kerntemperatur oder Temperaturverteilung. Gegebenenfalls wird auch ein Elektrowerkzeug, das mit dem Energiespeicher versorgt wird, unmittelbar mit der ermittelten Kerntemperatur gesteuert beziehungsweise geregelt.

Dies erlaubt es, beispielsweise durch die Zelle angetriebene Verbraucher rechtzeitig zu entkoppeln ebenso wie beispielsweise anliegende Ladespannungen zu trennen oder Ladeströme den errechneten Temperaturen innerhalb der Zelle nachzuführen (z.B. Laden bei tiefen Temperaturen).

BEZUGSZEICHENLISTE:

| | |
|---|---|
| 1 | Energiespeicher |
| 2 | Mantelfläche |
| 3 | Längsachse |
| 4 | Mittellinie |
| 5 | Zellkern |
| 6 | Temperaturverteilung |
| 7 | Temperatursensor |
| 8 | Akkupack |

| | |
|---|---|
| 9 | Elektrowerkzeug |
| 10 | Aufnahme |
| 11 | Gehäuse |
| 12 | Schnittstelle |
| $T_{Max}$ | Maximale Temperatur im Zellkern |
| $T_{rA}$ | Manteltemperatur |
| $T_{ZK}$ | Kerntemperatur |
| S1 | erster Schritt |
| S2 | zweiter Schritt |
| S3 | dritter Schritt |
| S4 | vierter Schritt |
| S5 | fünfter Schritt |
| S6 | sechster Schritt |
| S7 | siebter Schritt |

**Patentansprüche**

1. Verfahren zum Ermitteln einer Kerntemperatur ($T_{ZK}$) in einem Energiespeicher (1),
   **gekennzeichnet durch**

   - Messen (S1) einer Manteltemperatur ($T_{rA}$) des Energiespeichers (1),
   - Messen (S2) eines elektrischen Stroms durch den Energiespeicher (1) und
   - Ermitteln (S5) der Kerntemperatur ($T_{ZK}$) des Energiespeichers (1) mit Hilfe eines thermischen Modells aus der gemessenen Manteltemperatur ($T_{rA}$) und dem gemessenen elektrischen Strom.

2. Verfahren nach Anspruch 1,
   **dadurch gekennzeichnet, dass**
   der Energiespeicher (1) die Form eines geraden Zylinders besitzt und die Kerntemperatur ($T_{ZK}$) an einer Stelle einer Längsachse (3) des Energiespeichers (1) ermittelt wird.

3. Verfahren nach Anspruch 1 oder 2,
   **dadurch gekennzeichnet, dass**
   der Energiespeicher (1) die Form eines Kreiszylinders, eines elliptischen Zylinders oder eines Prismas, insbesondere Quaders, besitzt und die Kerntemperatur ($T_{ZK}$) im geometrischen Zentrum des Energiespeichers (1) ermittelt wird.

4. Verfahren nach einem der vorhergehenden Ansprüche,
   **dadurch gekennzeichnet, dass**
   der Energiespeicher (1) in dem thermischen Modell als homogener Körper betrachtet wird.

5. Verfahren nach Anspruch 4,
   **dadurch gekennzeichnet, dass**
   für das thermischen Modell eine mittlere Dichte und eine mittlere spezifische Wärmekapazität des Energiespeichers (1) aus gewichteten Stoffeigenschaften des Energiespeichers (1) gewonnen werden.

6. Verfahren nach einem der Ansprüche 2 bis 5,
   **dadurch gekennzeichnet, dass**
   mit dem thermischen Modell ausschließlich eine radiale Temperaturverteilung (6) einschließlich der Kerntemperatur ($T_{ZK}$) ermittelbar ist.

7. Verfahren nach einem der Ansprüche 2 bis 5,
   **dadurch gekennzeichnet, dass**
   mit dem thermischen Modell sowohl eine radiale Temperaturverteilung (6) als auch eine axiale Temperaturverteilung in dem Energiespeicher (1) ermittelbar (S5) sind.

8. Verfahren nach einem der vorhergehenden Ansprüche,
   **dadurch gekennzeichnet, dass**
   die Manteltemperatur ($T_{rA}$) des Energiespeichers (1) an einer Mantelstelle in axialer Mitte des Energiespeichers (1) oder an einer heißesten Mantelstelle gemessen wird.

9. Verfahren nach einem der vorhergehenden Ansprüche,
**dadurch gekennzeichnet, dass**
in dem thermischen Modell der Energiespeicher (1) mit einem einzigen RC-Glied simuliert wird.

10. Verfahren nach Anspruch 9,
**dadurch gekennzeichnet, dass**
in dem thermischen Modell eine Exponentialfunktion durch eine oder mehrere lineare Funktionen angenähert wird, die den Exponenten der Exponentialfunktion multipliziert mit einer Maximaltemperatur als Term aufweist/aufweisen.

11. Verfahren zum Steuern oder Regeln (S7) eines Betriebs eines Energiespeichers (1) durch Ermitteln(S5) einer Kerntemperatur ($T_{ZK}$) des Energiespeichers (1) gemäß einem der vorhergehenden Ansprüche und Steuern oder Regeln (S7) des Betriebs des Energiespeichers (1) in Abhängigkeit von der ermittelten Kerntemperatur ($T_{ZK}$).

12. Verfahren nach Anspruch 11, wobei eine Leistungsabgabe des Energiespeichers (1) an einen Verbraucher oder ein Ladestrom oder eine Ladespannung des Energiespeichers (1) in Abhängigkeit von der Kerntemperatur ($T_{ZK}$) gesteuert wird (S7).

13. Energiespeicher (1) mit einer Steuereinrichtung zum Durchführen eines Verfahrens nach einem der vorhergehenden Ansprüche.

14. Energiespeicher (1) nach Anspruch 13 mit mehreren Zellen (1), von denen jede einzeln durch das gleiche thermische Modell modelliert wird.

15. Elektrowerkzeug (9) mit einem Energiespeicher (1) nach Anspruch 13 oder 14.

16. Computerprogrammprodukt, umfassend Befehle, die bewirken, dass der Energiespeicher (1) des Anspruchs 13 oder 14, oder das Elektrowerkzeug (9) des Anspruchs 15 die Verfahrensschritte nach einem der Ansprüche 1 bis 12 ausführt.

Fig.1

Fig.2

Fig.3

— S1

— S2

— S3

— S4

— S5

— S6

— S7

Fig.4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102011080512 A1
- US 8829904 B2
- CN 105206888 A